Europäisches Patentamt

European Patent Office

Office européen des brevets

(19)

(11) **EP 0 716 523 B1**

(12) **EUROPÄISCHE PATENTSCHRIFT**

(45) Veröffentlichungstag und Bekanntmachung des
Hinweises auf die Patenterteilung:
**11.06.2003 Patentblatt 2003/24**

(51) Int Cl.[7]: **H04L 7/033**, H03D 13/00

(21) Anmeldenummer: **95118982.8**

(22) Anmeldetag: **01.12.1995**

(54) **Phasendetektor**

Phase detector

Détecteur de phase

(84) Benannte Vertragsstaaten:
**DE FR GB IT**

(30) Priorität: **06.12.1994 DE 4443416**

(43) Veröffentlichungstag der Anmeldung:
**12.06.1996 Patentblatt 1996/24**

(73) Patentinhaber: **SIEMENS
AKTIENGESELLSCHAFT
80333 München (DE)**

(72) Erfinder: **Müllner, Ernst, Dr. Ing.
D-80995 München (DE)**

(56) Entgegenhaltungen:
**EP-A- 0 408 780       DE-A- 3 428 393
US-A- 4 527 277**

- **LEE T H ET AL 'A 155-MHz clock recovery delay-
  and phase-locked loop' , IEEE JOURNAL OF
  SOLID-STATE CIRCUITS, DEC. 1992, USA, VOL.
  27, NR. 12, PAGE(S) 1736 - 1746 , ISSN 0018-9200
  * Seite 1741, Spalte 2, Zeile 6 - Seite 1742, Spalte
  2, Zeile 2 ***
- **HOGGE: 'A Self Correcting Clock Recovery
  Circuit' JOURNAL OF LIGHTWAVE
  TECHNOLOGY Bd. LT-3, Nr. 6, Dezember 1985,
  NEW YORK, USA, Seiten 1312 - 1314**
- **PRESTOPNIK: 'Digital Electronics', 1990,
  SAUNDER COLLEGE PUBLISHING,
  PHILADELPHIA, USA**

Anmerkung: Innerhalb von neun Monaten nach der Bekanntmachung des Hinweises auf die Erteilung des europäischen
Patents kann jedermann beim Europäischen Patentamt gegen das erteilte europäische Patent Einspruch einlegen.
Der Einspruch ist schriftlich einzureichen und zu begründen. Er gilt erst als eingelegt, wenn die Einspruchsgebühr
entrichtet worden ist. (Art. 99(1) Europäisches Patentübereinkommen).

EP 0 716 523 B1

**Beschreibung**

Die Erfindung betrifft einen Phasendetektor zur Ermittlung des Phasenunterschieds zwischen einem digitalisierten Datensignal und dem Taktsignal eines Empfangsgerätes und eine Entscheiderschaltung zu Amplituden-Regeneration des Datensignals.

Durch Vergleich des empfangenen Datensignals mit einem abgetasteten Datensignal wird als Regelkriterium ein Phasensignal gewonnen, das zur Frequenzeinstellung eines Taktgenerators dient oder dessen Phase nachstellt.

Ein bekannter Phasendetektor ist in IEEE, Journal of Lightwave Technologie, VOL. LT-3, No. 6,. Seite 1312 bis 1314 beschrieben. Dieser Phasendetektor besteht aus zwei von einem internen Takt gesteuerten D-Kippstufen und zwei EXCLUSIVE-OR-Gattern, wobei die Eingänge eines EXCLUSIVE-OR-Gatters jeweils mit dem Eingang und dem Ausgang einer Kippstufe verbunden sind. So werden ein Phasensignal und ein Vergleichssignal erzeugt, die voneinander subtrahiert werden und - durch ein Filter geglättet - einen Oszillator steuern, der das Taktsignal erzeugt.

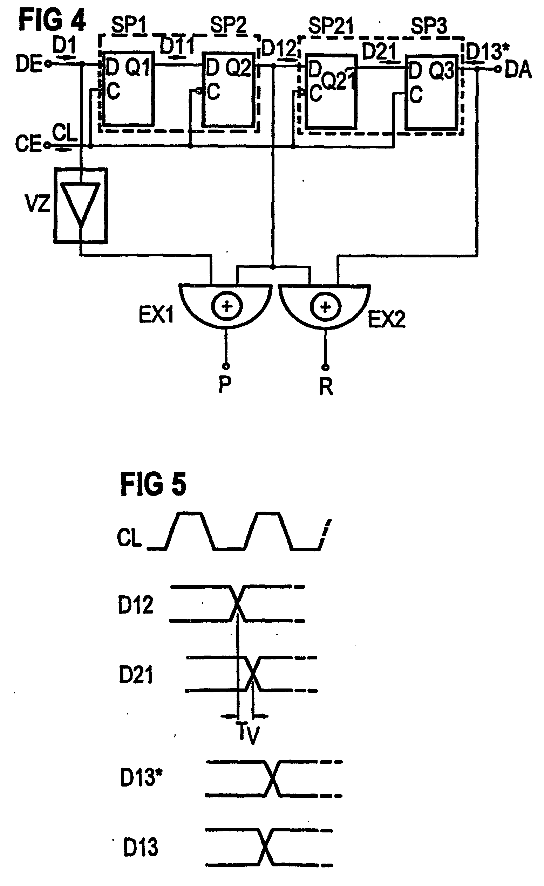

Für extrem hohe Frequenzen von beispielsweise 10 GHz werden aus Laufzeitgründen die Kippstufen jeweils aus zwei taktzustandsgesteuerten Speicherstufen aufgebaut, wie in Figur 4 dargestellt. Von jeder dieser Kippstufen wird jeweils die zweite Speicherstufe mit einem zur ersten Speicherstufe invertierten Taktsignal angesteuert bzw. intern so ausgebildet, daß sie auf den invertierten Zustand des Taktsignals reagiert.

Die Laufzeit der ersten Speicherstufe wird bei der Erzeugung des Phasensignals ausgeglichen, so daß das Datensignal exakt in der Mitte abgetastet wird.

Aus IEEE Journal Of Solid-State Circuits 27 (1992) December, No.12, New York, US P.1736 - 1746 sind Tri-Wave-Phasendetectoren beschrieben, bei denen Vergleichsspannungen von mehr als drei EXCLUSIVE-OR-Gattern erzeugt wird.

Bei beiden Phasendetektoren ergeben sich durch die Reihenschaltung der Kippstufen ungünstige Laufzeitbedingungen, so daß die Schaltung bei extrem hohen Datenraten Nachteile aufweist.

Außerdem sind die Ausgänge der an die EXCLUSIVE-OR-Gatter führenden Speicherstufen ungleich belastet, was zu Ungenauigkeiten beim Phasendetektor führt.

In den Fällen, in denen das anliegende Datensignal noch nicht seine volle Amplitude aufweist, ergeben sich durch den Verstärkereffekt der Kippstufen ungleiche Ausgangspegel, die bei der Zusammenfassung von Signalen in den EXCLUSIVE-OR-Gattern wiederum zu Ungenauigkeiten führen.

Aufgabe der Erfindung ist es, einen Phasendetektor hoher Genauigkeit für extrem hohe Datensignale anzugeben.

Diese Aufgabe wird in dem im Anspruch 1 angegebenen Phasendetektor gelöst.

Vorteilhafte Weiterbildungen sind in den Unteransprüchen angegeben.

Der besondere Vorteil des erfindungsgemäßen Phasendetektors, der auch gleichzeitig als Abtastschaltung dient, liegt in der unterschiedlichen Taktansteuerung der dritten Speicherstufe. Diese bildet mit der zweiten Speicherstufe quasi eine Master-Slave-Kippstufe, wodurch die Laufzeit der bisherigen dritten Speicherstufe entfällt.

Durch die den Eingängen der EXCLUSIVE-OR-Gatter vorgeschalteten Verstärkerstufen werden die Datensignale verstärkt und damit ihre Flanken versteilert, so daß ein präzises Schalten der Gatter gewährleistet ist. Außerdem sind die relevanten Kippstufenausgänge mit den Verstärkereingängen nur wenig und zudem gleich belastet, wodurch Laufzeitunterschiede vermieden werden.

Um eine maximale Datenrate verarbeiten zu können, werden die mit symmetrischen Eingängen und Ausgängen versehenen Speicherstufen mit antivalenten Daten- und Taktsignalen angesteuert.

Ein Ausführungsbeispiel der Erfindung wird anhand von Prinzipschaltbildern näher erläutert.

Es zeigen:

Fig. 1     den erfindungsgemäßen Phasendetektor,

Fig. 2     ein Zeitdiagramm zur Erläuterung der Funktionsweise des Phasendetektor,

Fig. 3     eine als Verzögerungsglied eingesetzte Speicherstufe

Fig. 4     eine bekannte Phasendetektorschaltung und

Fig. 5     ein Zeitdiagramm zur Erklärung der Laufzeitersparnis,

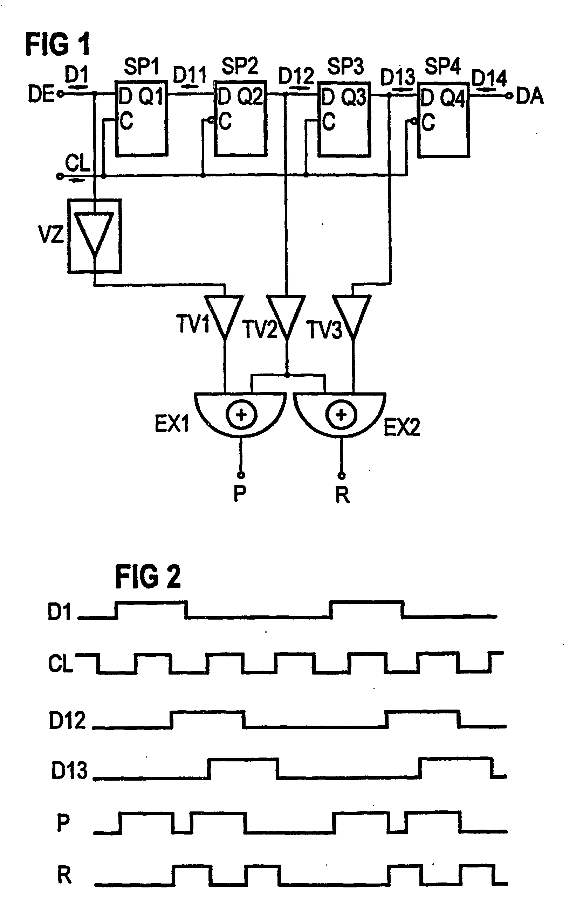

Die in Figur 1 dargestellte Schaltung des erfindungsgemäßen Phasendetektors weist vier in Serie geschaltete Speicherstufen SP1 bis SP4 auf, von denen aber nur die ersten drei zur Realisierung des Phasendetektors erforderlich sind. Die vierte Speicherstufe SP4 sorgt für gleiche Belastungen an den Datenausgängen Q2 und Q3 der zweiten und der dritten Kippstufe, die auch der Belastung des Dateneingangs DE entspricht. Der Ausgang Q4 der vierten Speicherstufe SP4 bildet den Datenausgang.

Über einen Dateneingang DE wird dem Dateneingang D der ersten Speicherstufe SP1 ein Datensignal D1 zugeführt. Dieser Dateneingang ist über ein Verzögerungsglied VZ und eine erste Verstärkerstufe (Treiberstufe) TV1 mit einem ersten Eingang eines ersten EXCLUSIVE-OR-Gatters EX1 (oder EXCLUSIVE-NOR-Gatters) verbunden. Der Datenausgang Q2 der zweiten Speicherstufe SP2 ist über eine zweite Verstärkerstufe TV2 mit einem zweiten Eingang des ersten EXCLUSIVE-OR-Gatters EX1 und mit einem ersten Eingang eines zweiten EXCLUSIVE-OR-Gatters EX2 verbunden. Dessen zweiter Eingang ist über eine dritte Verstärkerstufe TV3 an den Ausgang Q3 der dritten Speicherstufe SP3 angeschlossen. Die Speicherstufen SP1 bis SP4 werden von einem am Takteingang CE anliegenden Taktsignal CL gesteuert. Hierbei wird das Taktsignal entweder für jede zweite Speicherstufe SP2 und SP4 invertiert oder diese Speicherstufen reagieren auf einen invertierten Takt, wie dies durch Inverter an deren Takteingängen C symbolisch dargestellt ist. Ebenso können bei einer äquivalenten Lösung zwei unterschiedliche Taktsignale verwendet werden, deren wirksame Flanken jeweils um eine halbe Taktperiode verschoben sind.

Bei hohen Datenraten erfolgt die Signalverarbeitung mit symmetrischen Signalen, d.h. sowohl die Daten als auch das Taktsignal liegen zusätzlich invertiert vor. Einer Invertierung eines Taktsignales entspricht dann ein Vertauschen der beiden antivalenten Taktsignale.

In Figur 2 ist ein Zeitdiagramm zur Erläuterung der Funktion des Phasendetektors dargestellt. Das Datensignal D1 wird während der log.1 des Taktsignals CL an den Ausgang Q1 der ersten Speicherstufe SP1 durchgeschaltet und als Datensignal D12 mit der negativen Flanke des Taktsignals CL, mit der die zweite Speicherstufe SP2 in den nicht transparenten Zustand übergeht, an deren Datenausgang Q2 abgegeben. Eine halbe Taktperiode später wird das Datensignal D12 an den Ausgang der dritten Speicherstufe SP3 als nochmals verzögertes Datensignal D13 durchgeschaltet. Die Speicherstufen SP1 und SP2 können als eine Master-Slave-Kippstufe angesehen werden und ebenso die Speicherstufen SP2 und SP3. Durch die gemeinsam verwendete Speicherstufe SP2 - einmal als Slave und einmal als Masterstufe - wird eine Laufzeitersparnis möglich, auf die noch genauer eingegangen wird. Über die vierte Speicherstufe SP4 wird das Ausgangs-Datensignal D14 abgegeben.

Die Verstärkerstufen T1 bis T3 weisen eine geringe Eingangslast auf und verstärken die an ihren Eingängen anliegenden Eingangssignale, so daß auch bei einem geringen Pegel des Datensignals in den EXCLUSIVE-OR-Gattern nur Signale mit steilen Flanken verglichen werden.

Das erste EXCLUSIVE-OR-Gatter EX1 dient zur Gewinnung des Phasensignals P durch Vergleich des Datensignals D1 mit dem abgetasteten Datensignal D12 ( d.h. indirekt mit dem Taktsignal CL). Das zweite EXCLUSIVE-OR-Gatter EX2 gibt ein von der Phasenabweichung φ unabhängiges Referenzsignal R ab. Bei einem Phasenunterschied von φ = 0 stimmen das Phasensignals P und das Referenzsignal R bis auf eine konstante zeitliche Verzögerung überein.

Bei einem Phasendetektor mit minimaler Signallaufzeit werden nur drei Speicherstufen benötigt. Selbstverständlich können weitere Speicherstufen zwischen der ersten und zweiten und der zweiten und dritten Speicherstufe eingefügt werden, was in der Regel lediglich zur einer Aufwandsvergößerung führt. Das Phasensignal kann dann durch Vergleich des empfangenen Datensignals D1 mit einem später abgetastetem Datensignal gewonnen werden, entsprechendes gilt für das Referenzsignal.

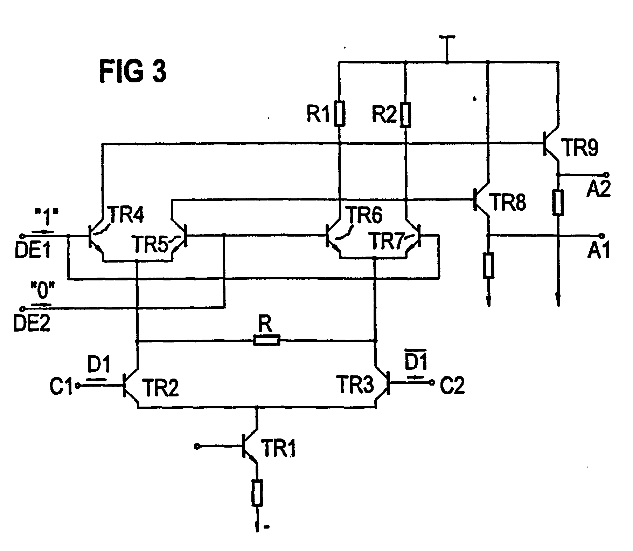

Das Verzögerungsglied VZ ist entsprechend einer Speicherstufe aufgebaut, um deren temperaturbedingte Laufzeitschwankungen zu kompensieren. In Figur 3 ist sein prinzipieller Aufbau dargestellt. Es besteht aus einem ersten Differenzverstärker TR1, TR2 und TR3 , an dessen Eingängen C1 und C2 zueinander antivalente Datensignale D1 und $\overline{D1}$ anstatt eines Taktsignals anliegen. Die Ausgänge der Verstärkertransistoren TR2 und TR3 sind mit den Emitteranschlüssen zweier weiterer Differenzstufen TR4, TR5 und TR6, TR7 verbunden. Deren Basisanschlüsse sind - im Gegensatz zur Verwendung als Speicherstufe - "über Kreuz" mit den Signaleingänge DE1 und DE2 verbunden und fest an die logische "1" bzw. logische "0" angeschaltet. Die Kollektoranschlüsse jeweils zweier Transistoren TR4,TR6 und TR5, TR7, an denen unterschiedliche Eingangspotentiale anliegen, sind zusammengeschaltet und über jeweils einen Widerstand R1 und R2 mit einem festen Potential verbunden und gleichzeitig über Impedanzwandler TR8 und TR9 auf Ausgänge A1 und A2 herausgeführt. Je nach Zustand des an die Takteingänge angeschalteten Datensignals D1 fließt durch einen dieser Widerstände jeweils Strom, der das Ausgangs-Datensignal erzeugt.

Da sich an den Kollektoranschlüssen der unteren Differenzstufe TR1, TR2, TR3 durch das als unregelmäßiges Taktsignal wirkendes Datensignal größere Potentialunterschiede im Vergleich zu einem regelmäßigen Takt ergeben, was zu einer Variation der Verzögerungszeit führt, ist ein Widerstand R zwischen den Kollektoren der Transistoren TR2 und TR3 eingeschaltet, der zum Ausgleich der Potentiale dient. Durch Einfügen dieses Widerstandes ist es auch bei Datensignalen mit längeren Folgen von Nullen oder Einsen auch möglich, die Laufzeit durch diese Stufe konstant zu halten.

In Figur 4 ist der bereits in der Einleitung beschriebene Phasendetektor dargestellt, bei dem die Kippstufen des in IEEE beschriebenen Phasendetektors aus jeweils zwei Speicherstufen aufgebaut sind. Einer seiner Nachteile liegt in der Ansteuerung der Speicherstufen. Figur 5 zeigt dies unter Berücksichtigung der Laufzeiten. Mit der negativen Flanke des Taktsignals CL wird während der log. 1 des Taktsignals das verzögerte Datensignal D11 vom Ausgang Q1 der ersten Speicherstufe SP1 in die Speicherstufe SP2 übernommen und erscheint weiter verzögert als Datensignal D12 an ihrem Ausgang Q2. Gleichzeitig ist auch die Speicherstufe SP21 transparent geschaltet, da sie vom selben invertierten Taktsignal $\overline{CL}$ angesteuert wird, und schaltet hierdurch das an ihrem Eingang anliegende Datensignal D12 um die Laufzeit $T_V$ nochmals verzögert als Datensignal D21 an ihren Ausgang Q21 durch. Zu Beginn der positiven Flanke des nächsten Taktimpulses liegt dieses Signal noch nicht am Eingang der Speicherstufe SP3 an, wodurch es zu einem verspätet abgegebenen Datensignal D13* und hierdurch zu einem Fehler bei der Funktion kommt.

Fällt dagegen die Verzögerungszeit $T_v$ der Speicherstufe SP22 weg, so kann das verzögerte Datensignal D12 problemlos mit der positiven Flanke des Taktsignals rechtzeitig durchgeschaltet werden und liegt als Datensignal D13 früher am Ausgang Q3 an.

## Patentansprüche

1. Phasendetektor mit mindestens drei in Serie geschalteten taktzustandsgesteuerten Speicherstufen (SP1, SP2, SP3, ...), die bei einem Taktzustand (z.B. log. 1) das Eingangssignal durchschalten und bei dem anderen Taktzustand (z.B. log. 0) das durchgeschaltete Signal speichern, von denen jede zweite Speicherstufe (SP2, ...) mit einem Taktsignal ($\overline{CL}$) angesteuert wird, dessen wirksame Flanken jeweils um eine halbe Taktperiode gegenüber den wirksamen Flanken des Taktsignals (CL) verschoben sind, mit denen die anderen Speicherstufen (SP1, SP3) getaktet werden,
mit einem ein Phasensignals (P) erzeugenden ersten EXCLUSIVE-OR/NOR-Gatter (EX1), dessen erstem Eingang ein am Dateneingang (D) einer ersten Speicherstufe (SP1) anliegendes Datensignal (D1) über ein Verzögerungsglied (VZ) zugeführt wird und dessen zweitem Eingang von einem Datenausgang (Q2) einer der ersten Speicherstufe (SP1) nachgeschalteten zweiten Speicherstufe (SP2) ein abgetaktetes Datensignal (D12) zugeführt wird,
und mit einem ein Referenzsignal (R) erzeugenden zweiten EXCLUSIVE-OR/NOR-Gatter (EX2), dessen erstem Eingang vom Datenausgang (Q2) einer der ersten Speicherstufe (SP1) nachgeschalteten Speicherstufe (SP2) ein abgetaktetes Datensignal (D12) und dessen zweitem Eingang vom Datenausgang (Q3) einer dieser nachgeschalteten Speicherstufe (SP2) unmittelbar nachgeschalteten weiteren Speicherstufe (SP3) ein gegenüber dem abgetakteten Datensignal (D12) um eine halbe Taktperiode verzögertes Datensignal (D13) zugeführt wird.

2. Phasendetektor nach Anspruch 1,
**dadurch gekennzeichnet,**
**daß** der zweite Eingang des ersten EXCLUSIVE-OR/NOR-Gatter (EX1) an den Datenausgang (Q2) der zweiten Speicherstufe (SP2) geführt ist und die Eingänge des zweiten EXCLUSIVE-OR/NOR-Gatter (EX2) jeweils an einen Datenausgang (Q2, Q3) der zweiten und einer der zweiten Speicherstufe (SP2) unmittelbar nachgeschalteten dritten Speicherstufe (SP2, SP3) geführt sind.

3. Phasendetektor nach einem der vorhergehenden Ansprüche,

**dadurch gekennzeichnet,**
**daß** den Eingängen der EXCLUSIVE-OR/NOR-Gatter (EX1, EX2) Verstärkerstufen (TV1, TV2, TV3) vorgeschaltet sind.

4. Phasendetektor nach Anspruch 3,
**dadurch gekennzeichnet,**
**daß** ein Eingang des ersten EXCLUSIVE-OR/NOR-Gatters (EX1) mit einem Eingang des zweiten EXCLUSIVE-OR/NOR-Gatters (EX2) zusammengeschaltet und an den Ausgang einer gemeinsamen Verstärkerstufe (TR2) angeschaltet ist.

5. Phasendetektor nach Anspruch 4,
**dadurch gekennzeichnet,**
**daß** an den Ausgängen der der Verstärkerstufen (TV1, TV2, TV3) gleiche Ausgangslasten durch das Anschalten weiterer Gattereingänge vorhanden sind.

6. Phasendetektor nach einem der vorhergehenden Ansprüche,
**dadurch gekennzeichnet,**
**daß** als Verzögerungsglied (VZ) eine modifizierte Speicherstufe vorgesehen ist, an deren Takteingang (C, $\overline{C}$) das Datensignal (D1, $\overline{D1}$) anliegt.

7. Phasendetektor nach Anspruch 6,
**dadurch gekennzeichnet,**
**daß** das Verzögerungsglied (VZ) aus Differenzstufen mit Transistoren aufgebaut ist,
**daß** eine erste Differenzstufe (TR1, TR2, TR3) vorgesehen ist, an deren Eingängen (C, $\overline{C}$) das Datensignal (D1, $\overline{D1}$) anliegt, daß ein Widerstand (R) zwischen den Kollektoren der Verstärkertransistoren (TR2, TR3) dieser Differenzstufe eingeschaltet ist,
**daß** jeweils an einen Kollektor eines der Verstärkertransistoren (TR2, TR3) der Differenzstufe die zusammengeschalteten Emitter von Transistoren zwei weiterer Differenzstufen (TR4, TR5; TR5, TR6) angeschlossen sind, und
**daß** die Eingänge (DE1, DE2) der weiteren Differenzstufen (TR4, TR5; TR5, TR6) an feste Potentiale angeschlossen sind.

8. Phasendetektor nach einem der vorhergehenden Ansprüche,
**dadurch gekennzeichnet,**
**daß** die Speicherstufen (SP1, SP2, SP3) für antivalente Datensignale (D1) und Taktsignale (CL) ausgeführt sind.

9. Phasendetektor nach einem der vorhergehenden Ansprüche,
**dadurch gekennzeichnet,**
**daß** eine vierte Speicherstufe (SP4) an den Ausgang (Q3) der dritten Speicherstufe (SP3) angeschaltet ist, an deren Ausgang das weiterzuverarbeitende Ausgangs-Datensignal (D14) abgegeben wird.

10. Phasendetektor nach einem der Ansprüche 2 bis 9, **dadurch gekennzeichnet,**
**daß** weitere Speicherstufen zwischen der ersten Speicherstufe (SP1) und der zweiten Speicherstufe (SP2) sowie zwischen der zweiten Speicherstufe (SP2) und der dritten Speicherstufe (SP3) eingeschaltet sind.

**Claims**

1. Phase detector having at least three series-connected, clock-state-controlled storage stages (SP1, SP2, SP3, ...), which switch through the input signal in the case of one clock state (e.g. log. 1) and store the switched-through signal in the case of the other clock state (e.g. log. 0), and of which each second storage stage (SP2, ...) is driven with a clock signal ($\overline{CL}$) whose effective edges are in each case shifted by half a clock period relative to the effective edges of the clock signal (CL) with which the other storage stages (SP1, SP3) are clocked,
having a first EXCLUSIVE-OR/NOR gate (EX1), which generates a phase signal (P), to whose first input a data signal (D1) present at the data input (D) of a first storage stage (SP1) is fed via a delay element (VZ) and to whose second input a clocked data signal (D12) is fed from a data output (Q2) of a second storage stage (SP2) connected downstream of the first storage stage (SP1),
and having a second EXCLUSIVE-OR/NOR gate (EX2), which generates a reference signal (R), to whose first input a clocked data signal (D12) is fed from the data output (Q2) of a storage stage (SP2) connected downstream of the first storage stage (SP1) and to whose second input a data signal (D13) delayed by half a clock period relative to the clocked data signal (D12) is fed from the data output (Q3) of a further storage stage (SP3) which is connected directly downstream of the said downstream-connected storage stage (SP2).

2. Phase detector according to Claim 1, **characterized**
**in that** the second input of the first EXCLUSIVE-OR/NOR gate (EX1) is connected to the data output (Q2) of the second storage stage (SP2) and the inputs of the second EXCLUSIVE-OR/NOR gate (EX2) are respectively connected to a data output (Q2, Q3) of the second and of a third storage stage (SP2, SP3), the latter being connected directly downstream of the second storage stage (SP2).

3. Phase detector according to one of the preceding claims,

**characterized**
**in that** amplifier stages (TV1, TV2, TV3) are connected upstream of the inputs of the EXCLUSIVE-OR/NOR gates (EX1, EX2).

4. Phase detector according to Claim 3, **characterized**
**in that** an input of the first EXCLUSIVE-OR/NOR gate (EX1) is interconnected with an input of the second EXCLUSIVE-OR/NOR gate (EX2) and is connected to the output of a common amplifier stage (TR2).

5. Phase detector according to Claim 4, **characterized**
**in that**, at the outputs of the amplifier stages (TV1, TV2, TV3), the same output loads are present as a result of the connection of further gate inputs.

6. Phase detector according to one of the preceding claims,
**characterized**
**in that** a modified storage stage is provided as delay element (VZ), the data signal (D1,$\overline{D1}$) being present at the clock input (C,$\overline{C}$) of the said storage stage.

7. Phase detector according to Claim 6, **characterized**
**in that** the delay element (VZ) is constructed from differential stages with transistors,
**in that** a first differential stage (TR1, TR2, TR3) is provided, at whose inputs (C,$\overline{C}$) the data signal (D1,$\overline{D1}$) is present,
**in that** a resistor (R) is connected in between the collectors of the amplifier transistors (TR2, TR3) of this differential stage,
**in that** the interconnected emitters of transistors of two further differential stages (TR4, TR5; TR5, TR6) are connected in each case to a collector of one of the amplifier transistors (TR2, TR3) of the differential stage, and
**in that** the inputs (DE1, DE2) of the further differential stages (TR4, TR5; TR5, TR6) are connected to fixed potentials.

8. Phase detector according to one of the preceding claims,
**characterized**
**in that** the storage stages (SP1, SP2, SP3) are embodied for non-equivalent data signals (D1) and clock signals (CL).

9. Phase detector according to one of the preceding claims,
**characterized**
**in that** a fourth storage stage (SP4) is connected to the output (Q3) of the third storage stage (SP3), at whose output the output data signal (D14) that is to be processed further is output.

10. Phase detector according to one of Claims 2 to 9, **characterized in that** further storage stages are connected in between the first storage stage (SP1) and the second storage stage (SP2) and between the second storage stage (SP2) and the third storage stage (SP3).

**Revendications**

1. Détecteur de phase comportant au moins trois étages à mémoire (SP1, SP2, SP3, ...), montés en série et contrôlés par les états de la cadence d'horloge, qui, dans un état de la cadence d'horloge (par exemple, le 1 logique), retransmettent le signal d'entrée et, dans l'autre état de la cadence d'horloge (par exemple, le 0 logique), mémorisent le signal connecté, l'un de deux étages de mémoire (SP2, ...) étant excité par un signal d'horloge ($\overline{CL}$), dont les flancs efficaces sont décalés, dans chaque cas, d'une demi période de la cadence d'horloge par rapport aux flancs efficaces du signal d'horloge (CL), avec lesquels les autres étages à mémoire (SP1, SP3) sont cadencés,
comportant une première grille OU/NON OU EXCLUSIVE (EX1), qui génère un signal de phase (P) et sur la première entrée de laquelle est envoyé, à travers un élément de temporisation (VZ), un signal de données (D1), appliqué à l'entrée de données (D) d'un premier étage de mémoire (SP1), et sur la deuxième entrée de laquelle est envoyé, par la sortie de données (Q2) d'un deuxième étage à mémoire (SP2) monté en aval du premier étage à mémoire (SP1), un signal de données cadencé (D12)
et comportant une deuxième grille OU/NON OU EXCLUSIVE (EX2), qui génère un signal de référence (R) et sur la première entrée de laquelle est envoyé, par la sortie de données (Q2) d'un étage à mémoire (SP2) monté en aval du premier étage à mémoire (SP1), un signal de données cadencé (D12) et sur la deuxième entrée de laquelle est envoyé, par la sortie de données (Q3) d'un autre étage à mémoire (SP3), monté directement en aval de cet étage à mémoire (SP2) monté en aval, un signal de données (D13), retardé d'une demi période de la cadence d'horloge par rapport au signal de données cadencé (D12).

2. Détecteur de phase selon la revendication 1 **caractérisé par le fait que** la deuxième entrée de la première grille OU/ NON OU EXCLUSIVE (EX1) est reliée à la sortie de données (Q2) du deuxième étage à mémoire (SP2) et que les entrées de la deuxième grille OU/ NON OU EXCLUSIVE (EX2) sont reliées chacune à une sortie de données (Q2, Q3) du deuxième étage à mémoire (SP2) et d'un troisième étage à mémoire (SP3) monté directement en aval du deuxième étage à mémoire (SP2).

3. Détecteur de phase selon l'une des revendications précédentes **caractérisé par le fait que** des étages amplificateurs (TV1, TV2, TV3) sont connectés devant les entrées des grilles OU/ NON OU EXCLUSIVE (EX1, EX2).

4. Détecteur de phase selon la revendication 3 **caractérisé par le fait qu'**une sortie de la première grille OU/NON OU EXCLUSIVE (EX1) est raccordée à une entrée de la deuxième grille OU/NON OU EXCLUSIVE (EX2) et à la sortie d'un étage amplificateur commun (TR2).

5. Détecteur de phase selon la revendication 4 **caractérisé par le fait que**, aux sorties des étages amplificateurs (TV1, TV2, TV3), il y a des charges de sortie identiques grâce au raccordement d'autres entrées de grille.

6. Détecteur de phase selon l'une des revendications précédentes **caractérisé par le fait qu'**il est prévu, en tant qu'élément de temporisation (VZ), un étage à mémoire modifié, sur l'entrée d'horloge duquel (C, $\overline{C}$) est appliqué le signal de données (D1, $\overline{D1}$).

7. Détecteur de phase selon la revendication 6 **caractérisé par le fait que** l'élément de temporisation (VZ) est constitué d'étages différentiels avec des transistors, **qu'**il est prévu un premier étage différentiel (TR1, TR2, TR3), sur les entrées duquel (C, $\overline{C}$) est appliqué le signal de données (D1, $\overline{D1}$), **qu'**une résistance (R) est connectée entre les collecteurs des transistors amplificateurs (TR2, TR3) de cet étage différentiel, **que**, dans chaque cas, sur un collecteur de l'un des transistors amplificateurs (TR2, TR3) de l'étage différentiel, sont raccordés les émetteurs connectés ensemble de transistors de deux autres étages différentiels (TR4, TR5; TR5, TR6) et **que** les entrées (DE1, DE2) des autres étages différentiels (TR4, TR5; TR5, TR6) sont raccordées sur des potentiels fixes.

8. Détecteur de phase selon l'une des revendications précédentes **caractérisé par le fait que** les étages à mémoire (SP1, SP2, SP3) sont conçus pour des signaux de données (D1) et des signaux d'horloge (CL) anticoïncidants.

**9.** Détecteur de phase selon l'une des revendications précédentes
**caractérisé par le fait**
**qu'**un quatrième étage à mémoire (SP4) est raccordé à la sortie (Q3) du troisième étage à mémoire (SP3), sur la sortie duquel est délivré le signal de données de sortie (D14) destiné à un traitement ultérieur.

**10.** Détecteur de phase selon l'une des revendications 2 à 9
**caractérisé par le fait**
**que** d'autres étages à mémoire sont connectés entre le premier étage à mémoire (SP1) et le deuxième étage à mémoire (SP2), ainsi que entre le deuxième étage à mémoire (SP2) et le troisième étage à mémoire (SP3).

## FIG 1

## FIG 2

FIG 3

FIG 4

FIG 5

EP 0 716 523 B1

10